(19) Europäisches Patentamt
European Patent Office
Office européen des brevets

(11) EP 1 701 183 A1

(12) EUROPEAN PATENT APPLICATION
published in accordance with Art. 158(3) EPC

(43) Date of publication:
**13.09.2006 Bulletin 2006/37**

(51) Int Cl.:
***G02B 5/30*** *(2006.01)*

(21) Application number: **04807294.6**

(86) International application number:
**PCT/JP2004/018936**

(22) Date of filing: **17.12.2004**

(87) International publication number:
**WO 2005/069047 (28.07.2005 Gazette 2005/30)**

(84) Designated Contracting States:
**AT BE BG CH CY CZ DE DK EE ES FI FR GB GR HU IE IS IT LI LT LU MC NL PL PT RO SE SI SK TR**

(30) Priority: **19.01.2004 JP 2004010827**

(71) Applicant: **NITTO DENKO CORPORATION**
**Ibaraki-shi,**
**Osaka 567-8680 (JP)**

(72) Inventor: **SHUTOU, Shunsuke**
**Nitto Denko Corporation**
**Osaka 567-8680 (JP)**

(74) Representative: **Vossius & Partner**
**Siebertstrasse 4**
**81675 München (DE)**

# (54) PHASE-CONTRAST FILM, PROCESS FOR PRODUCING PHASE-CONTRAST FILM, PROCESS FOR PRODUCING LAMINATED PHASE-CONTRAST FILM, OPTICAL FILM AND IMAGE DISPLAY UNIT

(57) The present invention provides a retardation film on which birefringent layers having different alignment directions can be formed directly. A surface of a polymer film showing birefringence is irradiated with polarized light so as to change an alignment direction of only the surface of the film to be different from an alignment direction of an inside of the film, thereby manufacturing a retardation film having the surface that is processed into an alignment surface. Since this film is a retardation film that also functions as an alignment film, if a liquid crystal layer is formed directly on the alignment surface and is aligned, the birefringent layer having the alignment direction that is different from the alignment direction of the retardation film can be formed on the retardation film.



Printed by Jouve, 75001 PARIS (FR)

## Description

### Technical Field

The present invention relates to a retardation film, a method for manufacturing a retardation film, a method for manufacturing a laminated retardation film, an optical film, and an image display apparatus.

### Background Art

Conventionally, various kinds of liquid display apparatuses have various problems on viewing angle properties such as a decrease in contrast ratios and an occurrence of tone reversal at black display parts when they are observed from oblique directions, and in order to improve these problems, various birefringent films (retardation films) are used as optical compensation films.

As these optical compensation films, for example, a negative uniaxial birefringent film using polyimide with optical characteristics that can be controlled by linearity and rigidity of a molecular skeleton, which is useful for normally white twisted nematic (TN) liquid crystal displays (for example, see Patent Document 1), and a negative uniaxial birefringent film using polyimide that includes a fluorene skeleton (for example, see Patent Document 2) are disclosed. The films made of non-liquid crystal polymers such as polyimide are very useful, also because sufficient retardations (Rth) in thickness directions can be achieved even if the films are thin, for example.

Conventionally, besides these, birefringent films using liquid crystal materials have been produced commercially as the thin optical compensation films. The optical compensation film using a liquid crystal material can be generally formed by: forming a coating film containing the liquid crystal material on an alignment film showing an anisotropy; and aligning the liquid crystal material in the coating film according to an alignment direction of the alignment film. That is, birefringence can be provided by the alignment of the liquid crystal material. As the alignment film used in such a manufacturing method, for example, a stretched film is disclosed (for example, see Patent Document 3), and it is generally known that the liquid crystal material disposed on the stretched film is aligned in a stretching direction of the stretched film.

As mentioned above, birefringent films using various formation materials are utilized as the optical compensation films. Recently, it has been further desired that optical characteristics (for example, birefringence) of the optical compensation films are set suitably according to the purposes thereof, such as operational modes of liquid crystal displays and application to various kinds of image display apparatuses except liquid crystal displays. Then, as a method for setting variations of the optical characteristics in wide ranges, for example, a method of combining various kinds of retardation films and laminating them is used.

Patent Document 1: US 5,344,916 A
Patent Document 2: US 6,074,709 A
Patent Document 3: JP Patent No. 2631015

### Disclosure of Invention

### Problem to be Solved by the Invention

Among the combinations of the various kinds of films, in particular, the inventors of the present invention have found to use, as the optical compensation film, a laminated retardation film that is obtained by laminating birefringent films having different alignment axis directions, based on the inventors' finding that such a laminated retardation film is advantageous that variation of its optical characteristics can be widened, and its optical characteristics can be set so as to be suitable for various image display apparatuses. However, since it generally requires to use an adhesive or the like for laminating plural birefringent films, the thus obtained laminated retardation film becomes thick even if it can obtain the optical characteristics, and it becomes hard for the laminated retardation film to satisfy the recent requirement of reducing thicknesses of image display apparatuses.

Whereas, if a stretched film showing birefringence is used not only as a birefringent film but also as an alignment film, a birefringent layer made of a liquid crystal compound can be laminated directly on the stretched film by using the alignment of the stretched film, and it is thought that the increase in thickness also can be prevented. However, as mentioned above, the liquid crystal compound is aligned in the stretching direction of the stretched film, that is, in an axial direction exhibiting a large refractive index within a plane of the stretched film, and thus the stretched film and the birefringent layer (liquid crystal layer) have the same angles of alignment axes, as a result, the purpose cannot be attained.

In light of the above-described conventional problems, it is an object of the present invention to provide a technique that can realize a laminated retardation film in which two or more birefringent layers having different alignment directions are laminated directly.

**Means for Solving Problem**

In order to attain the above-mentioned object, the retardation film of the present invention is a retardation film showing birefringence, wherein a non-liquid crystal polymer is included, the non-liquid crystal polymer is aligned, alignment of the non-liquid crystal polymer on at least one of surfaces of the retardation film is different from alignment of the non-liquid crystal polymer on an inside of the retardation film, and the surface having the alignment that is different from the alignment on the inside functions as an alignment surface.

In addition, the manufacturing method of a retardation film of the present invention includes a step of forming an alignment surface by irradiating at least one of surfaces of a polymer film showing birefringence with polarized light so as to change an alignment direction of only the surface of the polymer film that is irradiated with the polarized light.

And, the manufacturing method of a laminated retardation film of the present invention is a method for manufacturing a laminated retardation film in which two or more birefringent layers with different alignment directions are laminated, the method including: preparing the retardation film of the present invention; applying a coating solution containing a liquid crystal compound on the alignment surface of the retardation film so as to form a coating film; and subjecting the coating film to a heat treatment for aligning the liquid crystal compound according to an alignment direction of the alignment surface so as to form a birefringent layer.

**Effects of the Invention**

The inventors of the present invention have carried out a keen study aiming at laminating plural retardation films with different alignment directions (directions of alignment axes) directly without using an adhesive or the like. As a result, as mentioned above, they have found that, if at least one of surfaces (alignment surface) of the retardation film showing birefringence and an inside thereof have different alignment directions, a retardation film with a different alignment direction can be formed directly on the alignment surface of this retardation film. That is, since, in the retardation film of the present invention, its inside and at least one of its surfaces (alignment surface) have different alignment directions, if, for example, a liquid crystal layer or the like is formed directly on the surface (alignment surface), a liquid crystal compound of the liquid crystal layer is aligned according to the alignment direction of the surface (alignment surface). Accordingly, the retardation film as a base layer and the liquid crystal layer have different alignment directions. As mentioned above, since the retardation film of the present invention has not only a function inherent in a retardation film but also a function as an alignment film, a retardation film with a different alignment direction can be laminated thereon, and an increase in thickness can be prevented. Therefore, by using the retardation film of the present invention, a thin laminated retardation film having various optical characteristics can be provided, which is exceedingly useful for optical compensation of various kinds of image display apparatuses including liquid crystal displays. In addition, the retardation film of the present invention can be manufactured by the manufacturing method of a retardation film of the present invention. Moreover, according to the manufacturing method of a laminated retardation film of the present invention, the retardation film of the present invention is used as mentioned above, and thus a laminated retardation film in which two or more birefringent layers with different alignment directions are laminated directly can be manufactured. In the present invention, the retardation film of the present invention is also called a "surface-modified retardation film". Moreover, the modified surface is the "alignment surface" of the present invention.

**Best Mode for Carrying Out the Invention**

As mentioned above, the surface-modified retardation film of the present invention is a retardation film showing birefringence in which a non-liquid crystal polymer is contained and the non-liquid crystal polymer is aligned, wherein at least one of surfaces (alignment surface) of the retardation film has an alignment direction that is different from an alignment direction of an inside of the retardation film. Such an surface-modified retardation film can be used alone as the retardation film, but due to its above-described effect, it preferably is used as an alignment film and is used for optical compensation as a laminate with a birefringent layer formed directly on its surface (alignment surface).

In the retardation film of the present invention, the "alignment surface" means a surface having alignment that is different from the alignment of the inside of the film, on which the birefringent layer having alignment that is different from the alignment of the inside of the film is formed.

Optical characteristics of the retardation film of the present invention preferably show any of formulae (I) to (III) below. In addition, a negative uniaxial retardation film shown by the below formula (I) can be called a "negative C-Plate", and a positive uniaxial retardation film shown by the below formula (III) can be called a "positive A-Plate".

$$nx = ny > nz \quad (I)$$

$$nx > ny > nz \quad (II)$$

$$nx > ny = nz \quad (III)$$

In the above formulae (I) to (III), nx, ny and nz indicate refractive indices in an X-axis direction, a Y-axis direction and a Z-axis direction in the retardation film, respectively. The X-axis corresponds to an axial direction exhibiting a maximum refractive index within a plane of the retardation film, the Y-axis corresponds to an axial direction perpendicular to the X-axis within the plane, and the Z-axis corresponds to a thickness direction perpendicular to the X-axis and the Y-axis (hereinafter, they will be represented as described above).

The non-liquid crystal polymer preferably is a polymer such as polyamide, polyimide, polyester, polyetherketone, polyaryletherketone, polyamideimide, polyesterimide, because of its excellent heat resistance, chemical resistance, transparency and hardness. It may be possible to use one of these polymers alone or a mixture of two or more polymers having different functional groups, for example, a mixture of polyaryletherketone and polyamide. A molecular weight of such a non-liquid crystal polymer is not limited particularly, and can be determined suitably according to a viscosity, a concentration or the like of a solution of the non-liquid crystal polymer, for example. Specifically, the weight-average molecular weight (Mw) thereof preferably ranges from 1,000 to 1,000,000, and more preferably ranges from 2,000 to 500,000.

Among the exemplified polymers, polyimide is particularly preferable because of its high transparency, high alignment and high stretchability.

As the polyimide, it is preferable to use a polyimide that has high in-plane alignment and is soluble in an organic solvent. For example, it is possible to use a condensation polymer of 9,9-bis(aminoaryl)fluorene and an aromatic tetracarboxylic dianhydride disclosed in JP 2000-511296 A, more specifically, a polymer containing at least one repeating unit represented by the formula (1) below.

[Chemical Formula 1]

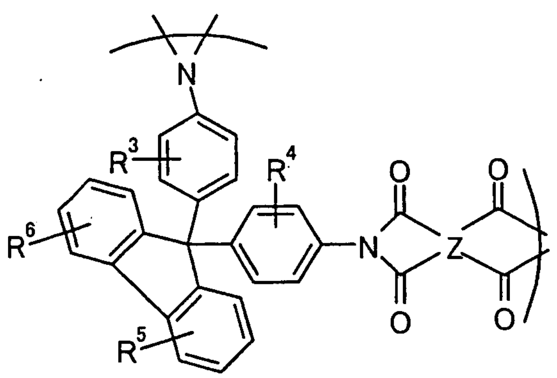

(1)

In the above formula (1), $R^3$ to $R^6$ are at least one substituent selected independently from the group consisting of hydrogen, halogen, a phenyl group, a phenyl group substituted with 1 to 4 halogen atoms or a $C_{1-10}$ alkyl group, and a $C_{1-10}$ alkyl group. Preferably, $R^3$ to $R^6$ are at least one substituent selected independently from the group consisting of halogen, a phenyl group, a phenyl group substituted with 1 to 4 halogen atoms or a $C_{1-10}$ alkyl group, and a $C_{1-10}$ alkyl group.

In the above formula (1), Z is, for example, a $C_{6-20}$ quadrivalent aromatic group, and preferably is a pyromellitic group, a polycyclic aromatic group, a derivative of a polycyclic aromatic group or a group represented by the formula (2) below.

[Chemical Formula 2]

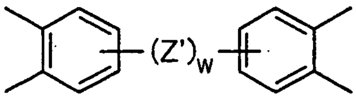

(2)

In the formula (2) above, Z' is, for example, a covalent bond, a $C(R^7)_2$ group, a CO group, an O atom, an S atom, an $SO_2$ group, an $Si(C_2H_5)_2$ group or an $NR^8$ group. When there are plural Z's, they may be the same or different. Also, w is an integer from 1 to 10. $R^7$s independently are hydrogen or $C(R^9)_3$. $R^8$ is hydrogen, an alkyl group having from 1 to about 20 carbon atoms or a $C_{6-20}$ aryl group, and when there are plural $R^8$s, they may be the same or different. $R^9$s independently are hydrogen, fluorine or chlorine.

The above-mentioned polycyclic aromatic group may be, for example, a quadrivalent group derived from naphthalene, fluorene, benzofluorene or anthracene. Further, a substituted derivative of the above-mentioned polycyclic aromatic group may be the above-mentioned polycyclic aromatic group substituted with at least one group selected from the group consisting of, for example, a $C_{1-10}$ alkyl group, a fluorinated derivative thereof and halogen such as F and Cl.

Other than the above, homopolymer whose repeating unit is represented by the general formula (3) or (4) below or polyimide whose repeating unit is represented by the general formula (5) below disclosed in JP 8(1996)-511812 A may be used, for example. The polyimide represented by the formula (5) below is a preferable mode of the homopolymer represented by the formula (3).

[Chemical Formula 3]

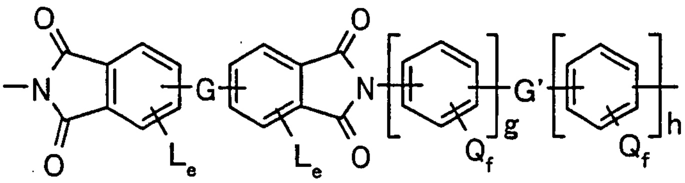

(3)

[Chemical Formula 4]

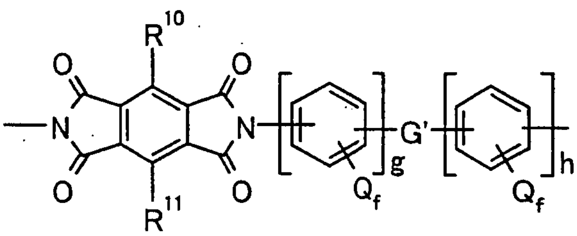

(4)

[Chemical Formula 5]

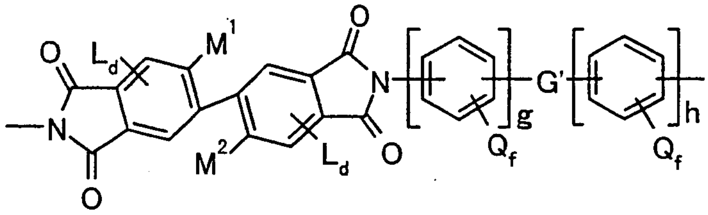

(5)

In the above general formulae (3) to (5), G and G' each are a group selected independently from the group consisting of, for example, a covalent bond, a $CH_2$ group, a $C(CH_3)_2$ group, a $C(CF_3)_2$ group, a $C(CX_3)_2$ group (wherein X is halogen), a CO group, an 0 atom, an S atom, an $SO_2$ group, an $Si(CH_2CH_3)_2$ group and an $N(CH_3)$ group, and G and G' may be the same or different.

In the above formulae (3) and (5), L is a substituent, and d and e indicate the number of substitutions therein. L is, for example, halogen, a $C_{1-3}$ alkyl group, a halogenated $C_{1-3}$ alkyl group, a phenyl group or a substituted phenyl group, and when there are plural Ls, they may be the same or different. The above-mentioned substituted phenyl group may be, for example, a substituted phenyl group having at least one substituent selected from the group consisting of halogen, a $C_{1-3}$ alkyl group and a halogenated $C_{1-3}$ alkyl group. Also, the above-mentioned halogen may be, for example, fluorine, chlorine, bromine or iodine. d is an integer from 0 to 2, and e is an integer from 0 to 3.

In the above formulae (3) to (5), Q is a substituent, and f indicates the number of substitutions therein. Q may be, for example, an atom or a group selected from the group consisting of hydrogen, halogen, an alkyl group, a substituted alkyl group, a nitro group, a cyano group, a thioalkyl group, an alkoxy group, an aryl group, a substituted aryl group, an alkyl ester group and a substituted alkyl ester group and, when there are plural Qs, they may be the same or different. The above-mentioned halogen may be, for example, fluorine, chlorine, bromine or iodine. The above-mentioned substituted alkyl group may be, for example, a halogenated alkyl group. Also, the above-mentioned substituted aryl group may be, for example, a halogenated aryl group. f is an integer from 0 to 4, and g and h respectively are an integer from 0 to 3 and an integer from 1 to 3. Furthermore, it is preferable that g and h are larger than 1.

In the above formula (4), $R^{10}$ and $R^{11}$ are groups selected independently from the group consisting of hydrogen, halogen, a phenyl group, a substituted phenyl group, an alkyl group and a substituted alkyl group. Among them, it is particularly preferable that $R^{10}$ and $R^{11}$ independently are a halogenated alkyl group.

In the above formula (5), $M^1$ and $M^2$ may be the same or different and, for example, halogen, a $C_{1-3}$ alkyl group, a halogenated $C_{1-3}$ alkyl group, a phenyl group or a substituted phenyl group. The above-mentioned halogen may be, for example, fluorine, chlorine, bromine or iodine. The above-mentioned substituted phenyl group may be, for example, a substituted phenyl group having at least one substituent selected from the group consisting of halogen, a $C_{1-3}$ alkyl group and a halogenated $C_{1-3}$ alkyl group.

A specific example of polyimide represented by the above formula (3) includes polyimide represented by the formula (6) below.

[Chemical Formula 6]

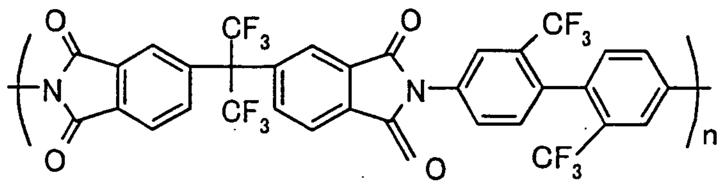

(6)

Moreover, the above-mentioned polyimide may be, for example, a copolymer obtained by copolymerizing acid dianhydride and diamine other than the above-noted skeleton (the repeating unit) suitably.

The above-mentioned acid dianhydride may be, for example, aromatic tetracarboxylic dianhydride. The aromatic tetracarboxylic dianhydride may be, for example, pyromellitic dianhydride, benzophenone tetracarboxylic dianhydride, naphthalene tetracarboxylic dianhydride, heterocyclic aromatic tetracarboxylic dianhydride or 2,2'-substituted biphenyl

tetracarboxylic dianhydride.

The pyromellitic dianhydride may be, for example, pyromellitic dianhydride, 3,6-diphenyl pyromellitic dianhydride, 3,6-bis(trifluoromethyl)pyromellitic dianhydride, 3,6-dibromopyromellitic dianhydride or 3,6-dichloropyromellitic dianhydride. The benzophenone tetracarboxylic dianhydride may be, for example, 3,3',4,4'-benzophenone tetracarboxylic dianhydride, 2,3,3',4'-benzophenone tetracarboxylic dianhydride or 2,2',3,3'-benzophenone tetracarboxylic dianhydride. The naphthalene tetracarboxylic dianhydride may be, for example, 2,3,6,7-naphthalene-tetracarboxylic dianhydride, 1,2,5,6-naphthalene-tetracarboxylic dianhydride or 2,6-dichloro-naphthalene-1,4,5,8-tetracarboxylic dianhydride. The heterocyclic aromatic tetracarboxylic dianhydride may be, for example, thiophene-2,3,4,5-tetracarboxylic dianhydride, pyrazine-2,3,5,6-tetracarboxylic dianhydride or pyridine-2,3,5,6-tetracarboxylic dianhydride. The 2,2'-substituted biphenyl tetracarboxylic dianhydride may be, for example, 2,2'-dibromo-4,4',5,5'-biphenyl tetracarboxylic dianhydride, 2,2'-dichloro-4,4',5,5'-biphenyl tetracarboxylic dianhydride or 2,2'-bis(trifluoromethyl)-4,4',5,5'-biphenyl tetracarboxylic dianhydride.

Other examples of the aromatic tetracarboxylic dianhydride may include 3,3',4,4'-biphenyl tetracarboxylic dianhydride, bis(2,3-dicarboxyphenyl)methane dianhydride, bis(2,5,6-trifluoro-3,4-dicarboxyphenyl)methane dianhydride, 2,2-bis(3,4-dicarboxyphenyl)-1,1,1,3,3,3-hexafluoropropane dianhydride, 4,4'-bis(3,4-dicarboxyphenyl)-2,2-diphenylpropane dianhydride, bis(3,4-dicarboxyphenyl)ether dianhydride, 4,4'-oxydiphthalic dianhydride, bis(3,4-dicarboxyphenyl)sulfonic dianhydride, 3,3',4,4'-diphenylsulfone tetracarboxylic dianhydride, 4,4'-[4,4'-isopropylidene-di(p-phenyleneoxy)]bis(phthalic anhydride), N,N-(3,4-dicarboxyphenyl)-N-methylamine dianhydride and bis(3,4-dicarboxyphenyl)diethylsilane dianhydride.

Among the above, the aromatic tetracarboxylic dianhydride preferably is 2,2'-substituted biphenyl tetracarboxylic dianhydride, more preferably is 2,2'-bis(trihalomethyl)-4,4',5,5'-biphenyl tetracarboxylic dianhydride, and further preferably is 2,2'-bis(trifluoromethyl)-4,4',5,5'-biphenyl tetracarboxylic dianhydride.

The above-mentioned diamine may be, for example, aromatic diamine. Specific examples thereof include benzenediamine, diaminobenzophenone, naphthalenediamine, heterocyclic aromatic diamine and other aromatic diamines.

The benzenediamine may be, for example, diamine selected from the group consisting of benzenediamines such as o-, m- and p-phenylenediamine, 2,4-diaminotoluene, 1,4-diamino-2-methoxybenzene, 1,4-diamino-2-phenylbenzene and 1,3-diamino-4-chlorobenzene. Examples of the diaminobenzophenone may include 2,2'-diaminobenzophenone and 3,3'-diaminobenzophenone. The naphthalenediamine may be, for example, 1,8-diaminonaphthalene or 1,5-diaminonaphthalene. Examples of the heterocyclic aromatic diamine may include 2,6-diaminopyridine, 2,4-diaminopyridine and 2,4-diamino-S-triazine.

Further, other than the above, the aromatic diamine may be 4,4'-diaminobiphenyl, 4,4'-diaminodiphenyl methane, 4,4'-(9-fluorenylidene)-dianiline, 2,2'-bis(trifluoromethyl)-4,4'-diaminobiphenyl, 3,3'-dichloro-4,4'-diaminodiphenyl methane, 2,2'-dichloro-4,4'-diaminobiphenyl, 2,2',5,5'-tetrachlorobenzidine, 2,2-bis(4-aminophenoxyphenyl)propane, 2,2-bis(4-aminophenyl)propane, 2,2-bis(4-aminophenyl)-1,1,1,3,3,3-hexafluoropropane, 4,4'-diaminodiphenyl ether, 3,4'-diaminodiphenyl ether, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, 4,4'-bis(3-aminophenoxy)biphenyl, 2,2-bis [4-(4-aminophenoxy)phenyl] propane, 2,2-bis[4-(4-aminophenoxy)phenyl]-1,1,1,3,3,3,-hexafluoropropane, 4,4'-diaminodiphenylthioether or 4,4'-diaminodiphenylsulfone.

The polyetherketone may be, for example, polyaryletherketone represented by the general formula (7) below, which is disclosed in JP 2001-49110 A.

[Chemical Formula 7]

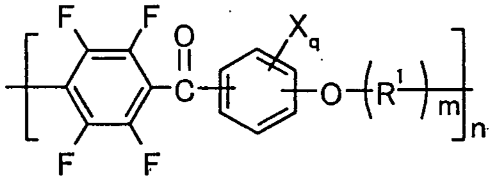

(7)

In the above formula (7), X is a substituent, and q is the number of substitutions therein. X is, for example, a halogen atom, a lower alkyl group, a halogenated alkyl group, a lower alkoxy group or a halogenated alkoxy group, and when there are plural Xs, they may be the same or different.

The halogen atom may be, for example, a fluorine atom, a bromine atom, a chlorine atom or an iodine atom, and among these, a fluorine atom is preferable. The lower alkyl group preferably is a $C_{1-6}$ straight or branched chain

lower alkyl group, and more preferably is a $C_{1-4}$ straight or branched chain alkyl group, for example. More specifically, it preferably is a methyl group, an ethyl group, a propyl group, an isopropyl group, a butyl group, an isobutyl group, a sec-butyl group or a tert-butyl group, and particularly preferably is a methyl group or an ethyl group. The halogenated alkyl group may be, for example, a halide of the above-mentioned lower alkyl group such as a trifluoromethyl group. The lower alkoxy group preferably is a $C_{1-6}$ straight or branched chain alkoxy group, and more preferably is a $C_{1-4}$ straight or branched chain alkoxy group, for example. More specifically, it further preferably is a methoxy group, an ethoxy group, a propoxy group, an isopropoxy group, a butoxy group, an isobutoxy group, a sec-butoxy group or a tert-butoxy group, and particularly preferably is a methoxy group or an ethoxy group. The halogenated alkoxy group may be, for example, a halide of the above-mentioned lower alkoxy group such as a trifluoromethoxy group.

In the above formula (7), q is an integer from 0 to 4. In the formula (7), it is preferable that q = 0, and a carbonyl group and an oxygen atom of an ether that are bonded to both ends of a benzene ring are present at para positions.

Also, in the above formula (7), $R^1$ is a group represented by the formula (8) below, and m is an integer of 0 or 1.

[Chemical Formula 8]

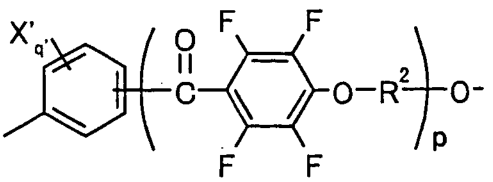

(8)

In the above formula (8), X' is a substituent, and is the same as X in the formula (7), for example. In the formula (8), when there are plural X's, they may be the same or different. q' indicates the number of substitutions in the X', and is an integer from 0 to 4, preferably, q' = 0. In addition, p is an integer of 0 or 1.

In the formula (8), $R^2$ is a divalent aromatic group. This divalent aromatic group is, for example, an o-, m- or p-phenylene group or a divalent group derived from naphthalene, biphenyl, anthracene, o-, m- or p-terphenyl, phenanthrene, dibenzofuran, biphenyl ether or biphenyl sulfone. In these divalent aromatic groups, hydrogen that is bonded directly to the aromatic may be substituted with a halogen atom, a lower alkyl group or a lower alkoxy group. Among them, the $R^2$ preferably is an aromatic group selected from the group consisting of the formulae (9) to (15) below.

[Chemical Formula 9]

(9)

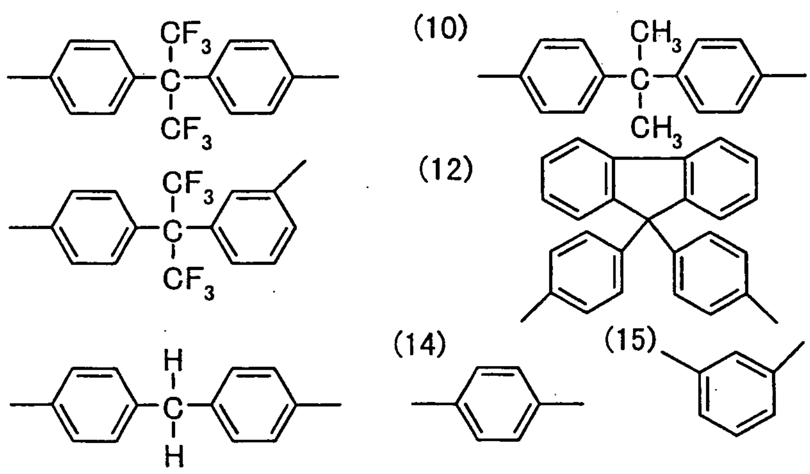

(10)

(11)

(12)

(13)

(14)

(15)

In the above formula (7), the $R^1$ preferably is a group represented by the formula (16) below, wherein $R^2$ and p are equivalent to those in the above-noted formula (8).

[Chemical Formula 10]

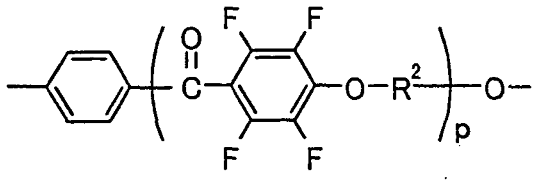

(16)

Furthermore, in the formula (7), n indicates a degree of polymerization ranging, for example, from 2 to 5000 and preferably from 5 to 500. The polymerization may be composed of repeating units with the same structure or those with different structures. In the latter case, the polymerization form of the repeating units may be a block polymerization or a random polymerization.

Moreover, it is preferable that an end on a p-tetrafluorobenzoylene group side of the polyaryletherketone represented by the formula (7) is fluorine and an end on an oxyalkylene group side thereof is a hydrogen atom. Such a polyaryletherketone can be represented by the general formula (17) below. In the formula below, n indicates a degree of polymerization as in the formula (7).

[Chemical Formula 11]

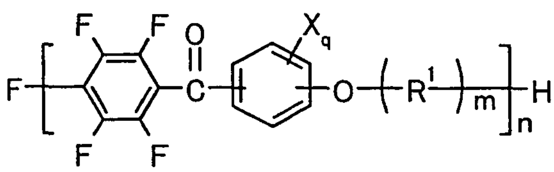

(17)

Specific examples of the polyaryletherketone represented by the above formula (7) may include those represented by the formulae (18) to (21) below, wherein n indicates a degree of polymerization as in the formula (7).

[Chemical Formula 12]

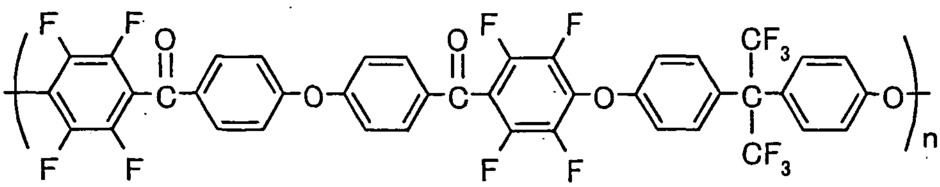

(18)

[Chemical Formula 13]

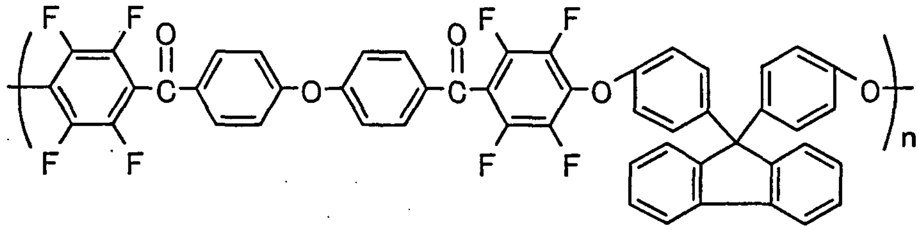

(19)

[Chemical Formula 14]

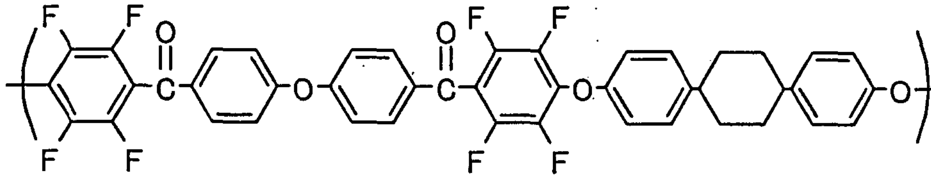

(20)

[Chemical Formula 15]

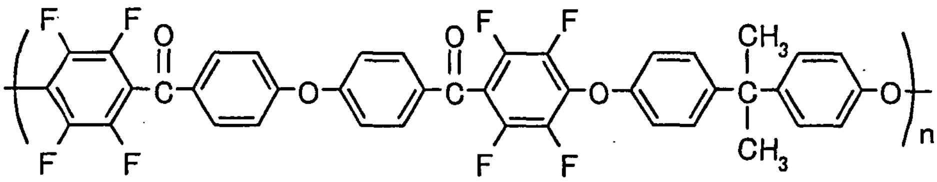

(21)

Other than the above, the polyamide or polyester may be, for example, polyamide or polyester described by JP 10(1998)-508048 A, and their repeating units can be represented by the general formula (22) below.

[Chemical Formula 16]

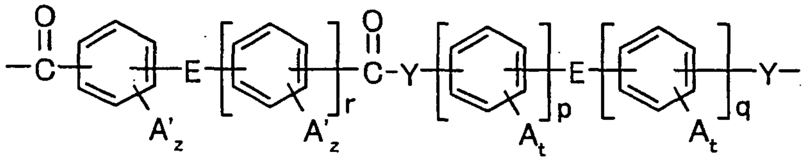

(22)

In the above formula (22), Y is O or NH. E is, for example, at least one group selected from the group consisting of a covalent bond, a $C_2$ alkylene group, a halogenated $C_2$ alkylene group, a $CH_2$ group, a $C(CX_3)_2$ group (wherein X is halogen or hydrogen), a CO group, an O atom, an S atom, an $SO_2$ group, an $Si(R)_2$ group and an N(R) group, and Es may be the same or different. In the above-mentioned E, R is at least one of a $C_{1-3}$ alkyl group and a halogenated $C_{1-3}$ alkyl group, and is present at a meta position or a para position with respect to a carbonyl functional group or a Y group.

Further, in the above formula (22), A and A' are substituents, and t and z respectively indicate the numbers of substitutions therein. Additionally, p is an integer from 0 to 3, q is an integer from 1 to 3, and r is an integer from 0 to 3.

The above-mentioned A is selected from the group consisting of, for example, hydrogen, halogen, a $C_{1-3}$ 3 alkyl group, a halogenated $C_{1-3}$ 3 alkyl group, an alkoxy group represented by OR (wherein R is the group defined above), an aryl group, a substituted aryl group by halogenation, a $C_{1-9}$ alkoxycarbonyl group, a $C_{1-9}$ alkylcarbonyloxy group, a $C_{1-12}$ aryloxycarbonyl group, a $C_{1-12}$ arylcarbonyloxy group and a substituted derivative thereof, a $C_{1-12}$ arylcarbamoyl group, and a $C_{1-12}$ arylcarbonylamino group and a substituted derivative thereof. When there are plural As, they may be the same or different. The above-mentioned A' is selected from the group consisting of, for example, halogen, a $C_{1-3}$ alkyl group, a halogenated $C_{1-3}$ alkyl group, a phenyl group and a substituted phenyl group, and when there are plural A's, they may be the same or different. A substituent on a phenyl ring of the substituted phenyl group can be, for example, halogen, a $C_{1-3}$ alkyl group, a halogenated $C_{1-3}$ alkyl group or a combination thereof. The t is an integer from 0 to 4, and the z is an integer from 0 to 3.

Among the repeating units of the polyamide or polyester represented by the formula (22) above, the repeating unit represented by the general formula (23) below is preferable.

[Chemical Formula 17]

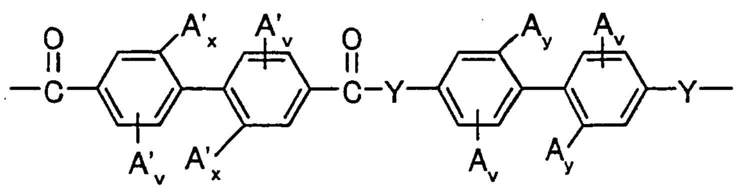

(23)

In the formula (23), A, A' and Y are those defined by the formula (22), and v is an integer from 0 to 3, and preferably is an integer from 0 to 2. Although each of x and y is 0 or 1, not both of them are 0.

Also, other than the above-mentioned polymers such as polyimide, the non-liquid crystal polymer may be, for example, a polymer of a liquid crystal compound. Specific description will be provided below, and for example, a film containing a liquid crystal compound is prepared, and the liquid crystal compound is aligned in a state of a liquid crystal phase and is polymerized while maintaining its state of alignment, whereby the film is processed into a film containing a polymer. In addition, unlike the liquid crystal compound as a constituent material of the polymer, the polymer shows non-liquid crystallinity due to the polymerization. Thus, examples of the non-liquid crystal polymer include the polymer of the liquid crystal compound.

The liquid crystal compound is not limited particularly, in-so-far as it is polymerizable. Specific examples thereof include a liquid crystal compound showing a nematic phase, a liquid crystal compound showing a discotic phase, and a liquid crystal compound showing a cholesteric phase. Also, a molecular form of the liquid crystal compound is not limited particularly, and may be rod-like, discotic or the like. In particular, in the case where a molecular disposition in the obtained polymer film is incline-aligned, it is preferable to use, for example, the rod-like liquid crystal compound.

Such a retardation film of the present invention can be manufactured by, for example, the manufacturing method of a retardation film of the present invention, but may be manufactured by other methods.

An example of the manufacturing method of the present invention will be described below, however, the present invention is not limited to this example. A polymer film showing birefringence is prepared. The polymer film is not limited particularly, in-so-far as an alignment direction of its surface alone can be changed by being irradiated with polarized light, which will be described in the next step, but it preferably is a film containing a non-liquid crystal polymer, for example.

A thickness of the polymer film ranges, for example, from 1 μm to 200 μm, preferably ranges from 1 μm to 100 μm, and more preferably ranges from 1 μm to 10 μm. Moreover, optical characteristics thereof preferably satisfy any of formulae (I) to (III) below, similarly to the above.

$$nx = ny > nz \quad (I)$$

$$nx > ny > nz \quad (II)$$

$$nx > ny = nz \quad (III)$$

A method for forming the polymer film is not limited particularly, however, in the case where the non-liquid crystal polymer is, for example, polyimide or the like as mentioned above, the polymer film can be formed by applying a coating solution containing the non-liquid crystal polymer on a surface of a base. If the solution contains the non-liquid crystal polymer, due to its characteristics, an anisotropy occurs in plane alignment regardless of the presence of the alignment of the base, that is, the anisotropy occurs in molecular alignment because the coating film is shrunk in a film thickness direction thereof by drying, for example. Thereby, the birefringent layer shows the optical characteristics of the negative uniaxiality represented by the above formula (I). The birefringent layer may be used alone by being peeled from the base, or may be used as a laminate with the base.

The polymer may be applied on the base by, for example, a heat melting method, however, for example, in the light of manufacturing efficiency and control of optical anisotropy, a method of applying a polymer solution obtained by solving or dispersing the non-liquid crystal polymer in a solvent is preferably used. In addition, the coating treatment suitably can be carried out by conventionally known methods such as spin coating, roller coating, flow coating, printing, dip coating, film flow-expanding, bar coating, and gravure printing, for example.

The solvent is not limited particularly, and for example, methylene chloride, cyclohexanone, trichloroethylene, tetrachloroethane, N-methylpyrrolidone, tetrahydrofuran or the like can be used suitably. It is preferable that, for example, in the light of viscosity, the polymer solution preferably contains 5 to 50 parts by weight of the non-liquid crystal polymer with respect to 100 parts by weight of the solvent, and more preferably, it contains 10 to 40 parts by weight of the non-liquid crystal polymer. In addition, the polymer solution may further contain various kinds of additives such as stabilizers, plasticizers and metals, as necessary.

After applying the coating solution on the base, for example, an air-drying or heat-drying treatment may be carried out, and the polymer can be fixed on the base by such a drying treatment, whereby the polymer film showing the birefringence can be formed. A condition of the heat-drying treatment preferably ranges from about 40°C to about 200°C, for example. A thickness of such a polymer film showing the birefringence ranges, for example, 0.1 μm to 100 μm, preferably ranges from 0.5 μm to 50 μm, and more preferably ranges from 2 μm to 10 μm.

Moreover, the polymer film showing the birefringence further may be stretched or shrunk, after it is formed. If the polymer film is stretched or shrunk as mentioned above, since refractive indices (nx, ny) within a plane further generate a difference therebetween, the optical characteristics of the birefringent layer can be changed from the negative uniaxiality to the negative biaxiality represented by the above formula (II).

In the case of carrying out the stretching or shrinking treatment, a birefringent index (Δn) of the polymer film showing the birefringence before the treatment, which is represented by a formula below, preferably is 0.01 or more, more preferably ranges from 0.02 to 0.2, and particularly preferably ranges from 0.03 to 0.1.

$$\Delta n = nx - nz$$

In the above formula, nx and nz indicate refractive indices in an X-axis direction and a Z-axis direction in the birefringent layer, respectively, and the X-axis corresponds to an axial direction exhibiting a maximum refractive index within a plane of the birefringent layer, and the Z-axis corresponds to a thickness direction perpendicular to the X-axis.

The stretching treatment can be carried out by various methods, for example, free-end uniaxial stretching, fixed-end uniaxial stretching, sequential uniaxial stretching, sequential biaxial stretching, simultaneous biaxial stretching, diagonal stretching and the like. In addition, a degree of the stretching is not limited particularly, and can be determined according to the required optical characteristics. A thickness of the polymer film showing the birefringence before the stretching treatment ranges, for example, from 0.1 μm to 100 μm, preferably ranges from 0.5 μm to 50 μm, and more preferably ranges from 2 μm to 10 μm. Whereas, a thickness of the polymer film showing the birefringence after the stretching treatment ranges, for example, 0.05 μm to 100 μm, preferably ranges from 0.25 μm to 50 μm, and more preferably ranges from 1 μm to 10 μm.

In the case of carrying out the shrinking treatment, for example, a method of changing a dimension of the base so as to shrink the polymer film showing the birefringence according to the dimensional change of the base, a method

of providing a shrinking property to the base in advance or the like can be used, and for example, a shrinkage ratio thereof also can be controlled by using a stretcher or the like. A thickness of the polymer film before the shrinking treatment ranges, for example, from 0.1 μm to 100 μm, preferably ranges from 0.5 μm to 50 μm, and more preferably ranges from 2 μm to 10 μm. A thickness of the polymer film after the shrinking treatment ranges, for example, from 0.1 μm to 100 μm, preferably ranges from 0.5 μm to 50 μm, and more preferably ranges from 2 μm to 10 μm.

Whereas, in the case where the non-liquid crystal polymer is, for example, the above-mentioned polymer of the liquid crystal compound or the like, the polymer film showing the birefringence is formed by, for example, applying a coating solution containing the liquid crystal compound on a surface of an alignment film so as to form a coating film, subjecting the coating film to a heat treatment so as to align the liquid crystal compound according to an alignment direction of the alignment film, and then polymerizing the liquid crystal compound. By using the liquid crystal compound as mentioned above, the liquid crystal compound shows liquid crystallinity, and thus can be aligned in a state of a liquid crystal phase, and the alignment can be fixed by further polymerizing the compound or the like. Moreover, although the used compound itself has liquid crystallinity, the polymer formed by the polymerization fixation has non-liquid crystallinity. Accordingly, since the formed polymer film showing the birefringence has an alignment structure like the liquid crystal phase, but is not composed of a liquid crystal molecule, for example, a phase change to a liquid crystal phase, a glass phase or a crystal phase due to its temperature change, which is peculiar to liquid crystal molecules, does not occur. Therefore, the alignment structure thereof has excellent stability, which is not affected by temperature change.

The optical characteristics of the polymer film containing such a polymer of the liquid crystal compound can be determined suitably according to a kind of the used liquid crystal compound or the like, for example. In particular, if a liquid crystal compound such as a rod-like liquid crystal showing a nematic layer or the like is used, a polymer film showing the optical characteristics represented by the above formula (III) can be obtained.

Since, for example, the liquid crystal compound generates a liquid crystal phase within a certain temperature range, a condition of the heat treatment of the coating film is preferably determined suitably according to the kind of the used liquid crystal compound. Moreover, after the heat treatment, a quenching treatment may be carried out so as to fix the state of the alignment of the liquid crystal compound.

A content of the liquid crystal compound in the coating solution ranges, for example, 10 to 50 parts by weight with respect to 100 parts by weight of a solvent, and preferably ranges from 20 to 30 parts by weight.
The solvent may be a conventionally known solvent similarly to the above. In addition, the coating film may further contain the above-described various kinds of additives, polymerizing agents, crosslinking agents and the like as necessary

Subsequently, at least one of surfaces of the polymer film showing the birefringence is irradiated with polarized light. Thereby, an alignment direction of the surface of the polymer film alone can be changed, and the polymer film can be structured so that its inside and its surface may have different alignment directions.

The reason why an alignment direction can be changed by polarized light is not certain, but is thought to be because an anisotropy can be provided due to decomposition of a polymer caused by irradiation with polarized light (for example, see Liquid Crystals 26, 575-580(1999)). Specifically, by the irradiation of the surface of the polymer film with polarized light, a constituent component (polymer) of the polymer film in a polarization direction is decomposed selectively. Thus, a refractive index in the polarization direction is decreased only on the surface of the polymer film. That is, the refractive index in the polarization direction becomes relatively small only on the surface of the polymer film, whereas, a refractive index in a direction at 90° with respect to the polarization direction becomes relatively large, and thus, the refractive indices generate the anisotropy.

The polarized light is, for example, polarized ultraviolet light, and preferably is polarized ultraviolet light of 200 nm to 400 nm. Moreover, linearly polarized light and elliptically polarized light are preferable, and linearly polarized ultraviolet light is particularly preferable.

According to the above-mentioned manufacturing method, the retardation film of the present invention that has both functions of a retardation film and an alignment film can be obtained. Such a retardation film can be, for example, used alone as a retardation film, and also can be used as an alignment film as mentioned above. In particular, due to its characteristics, it can be used as a film having both functions of an alignment film and a retardation film, when manufacturing a laminated retardation film including plural retardation films.

Next, an example of the manufacturing method of a laminated retardation film of the present invention will be described below. As mentioned above, this manufacturing method is characterized in that the retardation film of the present invention is used as an alignment film, and other structures thereof are not limited particularly. That is, the manufacturing method of a laminated retardation film of the present invention includes: preparing the retardation film of the present invention; applying a coating solution containing the liquid crystal compound on the alignment surface of the retardation film so as to form a coating film; and subjecting the coating film to a heat treatment for aligning the liquid crystal compound according to the alignment direction of the alignment surface so as to form a birefringent layer.

In the present invention, the liquid crystal compound is not limited particularly, in-so-far as it is aligned according to the alignment direction of the alignment film and the formed liquid crystal layer has birefringence, and various kinds of conventionally known liquid crystal compounds can be used. Specific examples thereof include a liquid crystal compound showing a nematic phase, a liquid crystal compound showing a discotic phase, and a liquid crystal compound showing a cholesteric phase. Also, they may be monomers (liquid crystal low-molecular-weight compounds) or polymers (liquid crystal high-molecular-weight compounds).

The coating solution may contain, for example, the above-described additives, crosslinking agents, polymerizing agents and the like, besides the liquid crystal compound. In addition, a method for applying the coating solution, a condition of drying, the heat treatment and the like may be determined in accordance with conventionally known methods, similarly to the above. Moreover, in the case where the liquid crystal compound is a polymerizable monomer, for example, it may be polymerized by, for example, photo polymerization, thermal polymerization or the like so as to fix its alignment.

In particular, a retardation film that shows the optical characteristics represented by the above formula (II) and uses the below-described polymer such as polyimide has been developed as, for example, an optical compensation film for a VA mode or an OCB mode by the inventors of the present invention (this invention already has been applied separately: JP Patent Application No. 2002-014529). If such a film is used for manufacturing the surface-modified retardation film of the present invention, and this surface-modified retardation film is used as the alignment film, a thinner and excellent optical compensation film can be obtained.

As mentioned above, on the surface-modified retardation film of the present invention that also functions as an alignment film, a birefringent layer in accordance with the alignment direction of the surface of the surface-modified retardation film is further formed, whereby a laminated retardation film in which alignment directions of the surface-modified retardation film and the birefringent layer are different, that is, slow axes directions thereof are different can be manufactured. Thus, the laminated retardation film of the present invention in which the surface-modified retardation film of the present invention and the birefringent layer are laminated directly is thin, and respective layers thereof have different alignment directions. Moreover, since variations of the optical characteristics that can be set are widened significantly, the manufacturing method is exceedingly useful in the optical fields.

Next, the optical film of the present invention includes the surface-modified retardation film or the laminated retardation film of the present invention. This optical film is only required to include any of the above-described films, and other structures and configurations thereof are not limited at all. For example, it further may include various kinds of conventionally known optical layers. The optical layers are not limited particularly, and may be various kinds of conventionally known optical layers that are used for various kinds of image display apparatuses, for example, polarizing elements, various kinds of retardation plates, diffusion-control films, brightness-enhancement films, reflection plates, semitransparent reflection plates and the like. These optical layers may be used in one kind or in combination of two kinds or more, and may be used as a single layer or a laminate of two layers or more.

The polarizing element may be, for example, a polarizer alone or a polarizing plate in which a transparent protective layer is laminated on at least one of surfaces of the polarizer. The transparent protective layer may be laminated on both of the surfaces of the polarizer, or may be laminated on only one of the surfaces thereof. In the case of laminating the transparent protective layers on both of the surfaces of the polarizer, they may be the same or different in kind, for example. Also, on the surface of the polarizer, the optical film of the present invention also may be laminated as a film that also functions as a transparent protective layer. In the case of using the laminated retardation film of the present invention, either the surface-modified retardation film or the birefringent layer may face the polarizing element, but it is preferable to laminate so that the birefringent layer may face the polarizing element.

The surface-modified retardation film or the laminated retardation film of the present invention and the polarizing element, and the polarizer and the transparent protective layer may be laminated by a general method, for example, laminated via conventionally known adhesives or pressure-sensitive adhesives. In addition, the laminated retardation film and the polarizing element may be just adhered by the adhesive or the like. Other than the above, the surface-modified retardation film of the present invention may be formed directly on the polarizer, for example, by using the polarizer as a substrate.

The polarizer (polarizing film) is not particularly limited but can be a film prepared by a conventionally known method of, for example, dyeing by allowing a film of various types such as a polyvinyl alcohol-based film to adsorb a dichroic material such as iodine or a dichroic dye, followed by crosslinking, stretching and drying. Especially, films that transmit linearly polarized light when natural light is made to enter those films are preferable, and films having excellent light transmittance and polarization degree are preferable. Examples of the film of various kinds in which the dichroic material is to be adsorbed include hydrophilic polymer films such as polyvinyl alcohol (PVA)-based films, partially-formalized PVA-based films, partially-saponified films based on an ethylene-vinyl acetate copolymer and cellulose-based films. Other than the above, polyene alignment films such as dehydrated PVA and dehydrochlorinated polyvinyl chloride can be used, for example. Among them, the PVA-based film is preferable. Further, generally, the polarizing film has a thickness in a range of 1 to 80 μm with no limitation thereto.

The protective layer is not particularly limited but can be a conventionally known transparent film. For example, transparent protective films having excellent transparency, mechanical strength, thermal stability, a moisture shielding property and isotropism are preferable. Specific examples of materials for such a transparent protective layer can include cellulose-based resins such as triacetylcellulose, and transparent resins based on polyester, polycarbonate, polyamide,

polyimide, polyethersulfone, polysulfone, polystyrene, polynorbornene, polyolefin, acrylic substances, acetate and the like. Thermosetting resins or ultraviolet-curing resins based on the acrylic substances, urethane, acrylic urethane, epoxy, silicones and the like can be used as well. Among them, a TAC film having a surface saponified with alkali or the like is preferable in the light of the polarization property and durability.

Furthermore, examples of the protective layer include the polymer film described in JP 2001-343529 A (WO 01/37007). The polymer material used can be a resin composition containing a thermoplastic resin whose side chain has a substituted or unsubtituted imido group and a thermoplastic resin whose side chain has a substituted or unsubtituted phenyl group and nitrile group, e.g., a resin composition containing an alternating copolymer of isobutene and N-methyl maleimide and an acrylonitrile-styrene copolymer. Alternatively, the polymer film may be formed by extruding the resin composition.

It is preferable that the protective layer is colorless, for example. More specifically, a retardation value (Rth) of the film in its thickness direction as represented by the formula below preferably ranges from -90 nm to +75 nm, more preferably ranges from -80 nm to +60 nm, and particularly preferably ranges from -70 nm to +45 nm. When the retardation value is within the range of -90 nm to +75 nm, coloring (optical coloring) of the polarizing element, which is caused by the protective film, can be solved sufficiently. In the equation below, nx, ny and nz are the same as those described above, and d represents a thickness of the protective film.

$$Rth = [\{(nx + ny)/2\} - nz] \cdot d$$

The transparent protective layer further may have an optically compensating function. As such a transparent protective layer having the optically compensating function, it is possible to use, for example, a known layer used for preventing coloring caused by changes in a visible angle based on retardation in a liquid crystal cell or for widening a preferable viewing angle. Specific examples include various stretched films obtained by stretching the above-described transparent resins uniaxially or biaxially, an alignment film of a liquid crystal polymer or the like, and a laminate obtained by providing an alignment layer of a liquid crystal polymer or the like on a transparent base. Among the above, the alignment film of a liquid crystal polymer is preferable because a wide viewing angle with excellent visibility can be achieved. Particularly preferable is an optically compensating retardation plate obtained by supporting an optically compensating layer with the above-mentioned triacetylcellulose film or the like, where the optically compensating layer is made of an incline-alignment layer of a discotic or nematic liquid crystal polymer.

This optically compensating retardation plate can be a commercially available product "WV film (trade name)" manufactured by Fuji Photo Film Co., Ltd, for example. Alternatively, the optically compensating retardation plate can be prepared by laminating two or more layers of the retardation film and the film support of triacetylcellulose film or the like so as to control the optical characteristics such as retardation.

The thickness of the transparent protective layer is not particularly limited, and can be determined suitably according to retardation or a protective strength, for example. In general, the thickness of the transparent protective layer is 500 μm or less, preferably ranges from 5 μm to 300 μm, and more preferably ranges from 5 μm to 150 μm.

The transparent protective layer can be formed suitably by a conventionally known method such as a method of applying the above-mentioned various transparent resins to a polarizing film or a method of laminating the transparent resin film, the optically compensating retardation plate, or the like on the polarizing film, or can be a commercially available product.

The transparent protective layer further may be subjected to, for example, a hard coating treatment, an antireflection treatment, treatments for anti-sticking, diffusion and anti-glaring and the like. The hard coating treatment aims to prevent scratches on the surfaces of the polarizing element, and is a treatment of, for example, providing a hardened coating film that is formed of a curable resin and has excellent hardness and smoothness on a surface of the transparent protective layer. The curable resin can be, for example, ultraviolet-curing resins based on silicone, urethane, acrylic substances, epoxy and the like. The treatment can be carried out by a conventionally known method. The anti-sticking treatment aims to prevent adjacent layers from sticking to each other. The antireflection treatment aims to prevent reflection of external light on the surface of the polarizing element, and can be carried out by forming a conventionally known antireflection layer or the like.

The anti-glare treatment aims to prevent reflection of external light on the polarizing element surface from hindering visibility of light transmitted through the polarizing element. The anti-glare treatment can be carried out, for example, by providing microscopic asperities on a surface of the transparent protective layer by a conventionally known method.

Such microscopic asperities can be provided by, for example, roughening the surface by sand-blasting or embossing, or by blending transparent fine particles in the above-described transparent resin when forming the transparent protective layer.

The above-described transparent fine particles may be silica, alumina, titania, zirconia, stannic oxide, indium oxide, cadmium oxide, antimony oxide, or the like. Other than the above, inorganic fine particles having an electrical conductivity, organic fine particles including, for example, crosslinked or uncrosslinked polymer particles, or the like can be used as well. The average particle diameter of the transparent fine particles ranges, for example, from 0.5 μm to 20 μm, though there is no particular limitation. In general, a blend ratio of the transparent fine particles preferably ranges from 2 to 70 parts by weight, and more preferably ranges from 5 to 50 parts by weight with respect to 100 parts by weight of the above-described transparent resin, though there is no particular limitation.

An anti-glare layer in which the transparent fine particles are blended can be used as the transparent protective layer itself, or provided as a coating layer or the like on the transparent protective layer surface. Furthermore, the anti-glare layer also can function as a diffusion layer for diffusing light transmitted through the polarizing element in order to widen the viewing angle (i.e., visually-compensating function).

The antireflection layer, the anti-sticking layer, the diffusion layer, the anti-glare layer and the like as mentioned above can be laminated on the polarizing element, as a sheet of optical layers including these layers, separately from the transparent protective layer.

As mentioned above, there is no particular limitation on the method of laminating the constituent members, and conventionally known methods can be employed. Kinds of a pressure-sensitive adhesive or an adhesive used can be determined suitably according to a material or the like of each of the constituent members. The adhesive can be, for example, a polymer adhesive based on acrylic substances, vinyl alcohol, silicone, polyester, polyurethane or polyether, or a rubber-based adhesive. It also is possible to use an adhesive containing a water-soluble crosslinking agent of vinyl alcohol-based polymers, such as glutaraldehyde, melamine and oxalic acid. The pressure-sensitive adhesive and the adhesive mentioned above do not peel off easily even when being exposed to moisture or heat, for example, and have excellent light transmittance and polarization degree. More specifically, PVA-based adhesives are preferable when the polarizer is a PVA-based film, in light of stability of an adhering treatment, for example. These adhesive and pressure sensitive adhesive may be applied directly on surfaces of the polarizer and the transparent protective layer, or a layer of a tape or a sheet formed of the adhesive or pressure sensitive adhesive may be arranged on the surfaces thereof. Further, when these adhesive and pressure sensitive adhesive are prepared as an aqueous solution, for example, other additives or a catalyst such as an acid catalyst may be blended as necessary. In the case of applying the adhesive, for example, other additives or a catalyst such as an acid catalyst further may be blended in the aqueous solution of the adhesive. The thickness of the adhesive layer is not particularly limited, but may be, for example, 1 nm to 500 nm, preferably 10 nm to 300 nm, and more preferably 20 nm to 100 nm. It is possible to adopt a conventionally known method of using an adhesive etc. such as an acrylic polymer or a vinyl alcohol-based polymer without any particular limitations. Moreover, it is preferable to use an adhesive further containing a water-soluble crosslinking agent of PVA-based polymers, such as glutaraldehyde, melamine and oxalic acid, because it can form a polarizing element that does not peel off easily even when being exposed to moisture or heat, and have excellent light transmittance and polarization degree. These adhesives can be used, for example, by applying its aqueous solution on the surface of each constituent member mentioned above, followed by drying. In the above aqueous solution, other additives or a catalyst such as an acid catalyst may be blended as necessary. Among these, the adhesive preferably is a PVA-based adhesive because an excellent adhesiveness to a PVA film can be achieved.

In addition, the retardation film may be a film that is prepared by, for example, stretching a polymer film uniaxially or biaxially, or subjecting the polymer film to Z-axis alignment, or a coating film of a liquid crystal polymer. The diffusion-control films may be films that utilize diffusion, scattering and refraction, and they can be used for controlling viewing angles, or for controlling glaring and scattered light that will affect definition, for example. The brightness-enhancement films may include a brightness-enhancement film using a selective reflector of a cholesteric liquid crystal and a λ/4 wavelength plate (λ/4 plate), and a scattering film utilizing an anisotropic scatter depending on a polarization direction. Moreover, the optical film may include, for example, a wire grid polarizer.

Next, as examples of the optical film of the present invention, a reflective polarizing plate that further includes a reflection plate, and a semitransparent reflective polarizing plate that further includes a semitransparent reflection plate will be described respectively.

In general, the reflective polarizing plate is arranged on a backside of a liquid crystal cell, and can be used in a liquid crystal display (reflective liquid crystal display) or the like that displays by reflecting incident light from a visible side (display side). Such a reflective polarizing plate is advantageous in that, for example, it can decrease a thickness of the liquid crystal display because the necessity of providing a light source such as a backlight can be eliminated.

The reflective polarizing plate can be formed in any known manner such as forming a reflection plate made of a metal or the like on one surface of the surface-modified retardation film or the laminated retardation film of the present invention, for example. More specifically, one example thereof is a reflective polarizing plate formed by matting one surface (surface to be exposed) of a transparent protective layer of the polarizing plate as required, and providing the surface with a metal foil formed of a reflective metal such as aluminum or a deposited film as a reflection plate.

Another example is a reflective polarizing plate prepared by forming, on the transparent protective layer having

a surface with microscopic asperities due to microparticles contained in various transparent resins as mentioned above, a reflection plate corresponding to the microscopic asperities. The reflection plate having a surface with microscopic asperities diffuses incident light irregularly so that directivity and glare can be prevented and irregularity in color tone can be controlled. The reflection plate can be formed by attaching the metal foil or the metal deposited film directly on the surface with asperities of the transparent protective layer by any conventionally known methods including deposition and plating, such as vacuum deposition, ion plating, and sputtering.

As mentioned above, the reflection plate can be formed directly on the transparent protective layer of the polarizing plate. Alternatively, a reflecting sheet or the like formed by providing a reflecting layer on a proper film such as the transparent protective film can be used as the reflection plate. Since a typical reflecting layer of a reflection plate is made of a metal, it is preferably used in a state that the reflecting surface of the reflecting layer is coated with the film, a polarizing plate or the like, in order to prevent a reduction of the reflectance due to oxidation, and furthermore, to allow the initial reflectance to be maintained for a long period and to avoid the necessity of forming a transparent protective layer separately.

On the other hand, the semitransparent polarizing plate is provided by replacing the reflection plate in the above-mentioned reflective polarizing plate by a semitransparent reflection plate. Examples of the semitransparent polarizing plate include a half mirror that reflects and transmits light at the reflecting layer.

In general, such a semitransparent polarizing plate is arranged on a backside of a liquid crystal cell. In a liquid crystal display including the semitransparent polarizing plate, incident light from the visible side (display side) is reflected to display an image when a liquid crystal display is used in a relatively bright atmosphere, while in a relatively dark atmosphere, an image is displayed by using a built-in light source such as a backlight on the backside of the semitransparent polarizing plate. In other words, the semitransparent polarizing plate can be used to form a liquid crystal display that can save energy for a light source such as a backlight under a bright atmosphere, while a built-in light source can be used under a relatively dark atmosphere.

The following description concerns an example of a polarizing plate prepared by further laminating a brightness-enhancement film on the laminated polarizing plate according to the present invention.

A suitable example of the brightness-enhancement film is not particularly limited, but it can be selected from a multilayer thin film of a dielectric or a laminate of multiple thin films with varied refraction aeolotropy that transmits linearly polarized light having a predetermined polarization axis while reflecting other light. Examples of such a brightness-enhancement film include "D-BEF (trade name)" manufactured by 3M Co. Also, a cholesteric liquid crystal layer, more specifically, an alignment film of a cholesteric liquid crystal polymer or an alignment liquid crystal layer fixed onto a supportive film base can be used as a brightness-enhancement film. Such a brightness-enhancement film reflects either clockwise or counterclockwise circularly polarized light while it transmits other light. Examples of such a brightness-enhancement film include "PCF 350 (trade name)" manufactured by Nitto Denko Corporation, "Transmax (trade name)" manufactured by Merck and Co., Inc., and the like.

Moreover, it is preferable that the above-mentioned optical film of the present invention further have a pressure-sensitive adhesive layer or an adhesive layer on its surface so as to allow easier lamination onto the other members such as a liquid crystal cell. These adhesive layers can be arranged on one surface or both surfaces of the optical film. The material for the pressure-sensitive adhesive layer is not particularly limited, but can be a conventionally known material such as acrylic polymers. In particular, a pressure-sensitive adhesive layer having a low moisture absorption coefficient and an excellent thermal resistance is preferable from the aspects of prevention of foaming or peeling caused by moisture absorption, prevention of degradation in the optical characteristics and warping of a liquid crystal cell caused by difference in thermal expansion coefficients, a capability of forming a liquid crystal display with high quality and excellent durability, and the like. It also may be possible to incorporate fine particles so as to form the pressure-sensitive adhesive layer showing light diffusion property. For the purpose of forming the pressure-sensitive adhesive layer on the surface of the polarizing plate, a solution or melt of a sticking material can be applied directly on an exposed surface of the optical film by a development method such as flow-expansion and coating. Alternatively, a pressure-sensitive adhesive layer can be formed on a separator, which will be described below, in the same manner, and transferred to the exposed surface of the optical film. Such a layer can be formed on any surface of the optical film.

When a surface of the pressure-sensitive adhesive layer or the like provided on the optical film is exposed, the surface preferably is covered with a separator until the time the pressure-sensitive adhesive layer is used so that contamination will be prevented. The separator can be formed by coating, on a proper film such as the transparent protective film, a peeling layer including a peeling agent containing silicone, long-chain alkyl, fluorine, molybdenum sulfide or the like as required.

The pressure-sensitive adhesive layer can be a monolayer or a laminate, for example. The laminate can include monolayers different from each other in the type or in the compositions. When arranged on both surfaces of the optical film, the pressure-sensitive adhesive layers can be same or can be different from each other in the type or in the compositions, for example.

A thickness of the pressure-sensitive adhesive layer can be determined appropriately depending on the constituents or the like of the optical film. In general, the thickness of the pressure-sensitive adhesive layer ranges from 1 μm to 500 μm.

It is preferable that the pressure-sensitive adhesive layer is made of a pressure-sensitive adhesive having excellent optical transparency and appropriate sticking characteristics such as wettability, cohesiveness, and adhesiveness. The pressure-sensitive adhesive can be prepared appropriately based on polymers such as an acrylic polymer, a silicone-based polymer, polyester, polyurethane, polyether, and synthetic rubber.

The sticking characteristics of the pressure-sensitive adhesive layer can be controlled suitably by a conventionally know method, for example, controlling a degree of crosslinkage or a molecular weight of the pressure-sensitive adhesive layer according to a composition or a molecular weight of the base polymer that forms the pressure-sensitive adhesive layer, a crosslinking method, a content ratio of a crosslinking functional group, a content ratio of a crosslinking agent or the like.

The optical film of the present invention as mentioned above and various kinds of members composing this may be treated suitably with an UV absorber such as salicylate ester compounds, benzophenone compounds, benzotriazole compounds, cyanoacrylate compounds, and nickel complex salt-based compounds so as to provide an UV absorbing capability.

The optical film of the present invention preferably is used in an image display apparatus, in particular, a liquid crystal display. For example, the optical film of the present invention may be disposed on one or both surfaces of a liquid crystal cell so as to form a liquid crystal panel, which can be used in a liquid crystal display of a reflection type, a semitransparent type, a transmission-reflection type or the like.

A kind of the liquid crystal cell to compose the liquid crystal display can be selected arbitrarily. For example, it is possible to use various types of liquid crystal cells such as an active matrix driving type represented by a thin film transistor, and a simple matrix driving type represented by a twist nematic type and a super twist nematic type. Specifically, various kinds of cells such as STN (Super Twisted Nematic) cells, TN (Twisted Nematic) cells, IPS (In-Plane Switching) cells, VA (Vertical Nematic) cells, OCB (Optically Aligned Birefringence) cells, HAN (Hybrid Aligned Nematic) cells, ASM (Axially Symmetric Aligned Microcell) cells, ferroelectric cells, antiferroelectric cells, and those subjected to systematic alignment-division or random alignment-division can be applied. Among them, the optical film of the present invention is excellent particularly in optical compensation of VA (Vertical Aligned) cells, and thus is significantly useful as a viewing-angle compensating film for VA mode liquid crystal displays.

In general, the liquid crystal cell has a structure where liquid crystal is injected into a space between liquid crystal cell substrates that are arranged facing each other. The liquid crystal cell substrates are not limited particularly, and can be glass substrates or plastic substrates, for example. In addition, materials for the plastic substrates are not limited particularly, and can be conventionally known materials.

In the case where optical members are disposed on both surfaces of the liquid crystal cell, the optical film of the present invention may be disposed on both surfaces thereof, or may be disposed only on any one of the surfaces thereof. They may be the same or different in kind. Moreover, for forming the liquid crystal display, one or more layers of appropriate members such as, for example, a prism array sheet, a lens array sheet, an optical diffusing plate and a backlight can be disposed at appropriate positions.

The optical film of the present invention can be used not only in the above-described liquid crystal displays but also in self-light-emitting displays such as an organic electroluminescence (EL) display, a PDP and a FED, for example. These image display apparatuses also are not limited particularly in-so-far as they include the optical film of the present invention, and can have structures or configurations that are the same as those of conventional image display apparatuses. In the case of using the optical film of the present invention in a self-light-emitting display, the optical film of the present invention with, for example, an in-plane retardation $\Delta nd$ of $\lambda/4$ is very useful as an antireflection filter, because it can obtain circularly polarized light.

Example 1

Hereinafter, the present invention will be described more specifically by way of examples and comparative examples. However, the present invention is not limited to them.

(Example 1)

Polyimide powder represented by the above formula (6) was synthesized by using 2,2-bis(3,4-dicarboxyphenyl) hexafluoropropane and 2,2'-bis(trifluoromethyl)-4,4'-diaminobiphenyl. Herein, a weight-average molecular weight of this polyimide was 130,000.

This polyimide powder was dissolved in methylisobutyl ketone so as to prepare a polyimide solution of 20 wt%. This polyimide solution was applied consecutively on a surface of a TAC film (length of 200 m, width of 350 mm, thickness of 80 μm, manufactured by Fuji Photo Film Co., Ltd.) by blade coating, and the coating film was dried at 130°C for 2

minutes. A thickness of the coating film after being dried was 6.7 μm. Moreover, the coating film was stretched with the TAC film by 1.3 times by fixed-end transverse stretching under a condition of 160°C. Herein, a stretching magnification indicates a ratio with respect to a length of the untreated coating film. By this stretching, the coating film was processed into an optically biaxial polyimide film.

Subsequently, a surface of the biaxial polyimide film on the TAC film was irradiated with polarized UV light (wavelength of 310 nm) for 30 minutes by using a polarized UV light exposure apparatus (irradiation energy at the wavelength of 310 nm was 5 mW/$cm^2$; manufactured by SEN ENGINEERING CO., LTD). Herein, the irradiation with polarized UV light was conducted in a stretching direction of the biaxial polyimide film that was a direction of the main refractive index nx. Thereby, a surface-modified polyimide film was manufactured. This laminate of the TAC film and the surface-modified polyimide film was a base sample.

(Example 2)

A laminate of the TAC film and a surface-modified polyimide film was manufactured in the same manner as Example 1, except that the irradiation with polarized UV light was conducted in a direction at 45° with respect to the stretching direction of the biaxial polyimide film, and this laminate was used as a base sample.

(Comparative Example 1)

A laminate of the TAC film and a biaxial polyimide film was manufactured in the same manner as Example 1, except that the biaxial polyimide film was not irradiated with polarized UV light, and this laminate was used as a base sample.

On a surface of the polyimide film of each of the thus obtained base samples of Examples 1, 2 and Comparative Example 1, a liquid crystal layer was further formed as described below so as to manufacture an optical film. An optical anisotropy of this optical film was evaluated by detecting a slow axis direction described below. This detection was conducted at some stages in the steps for manufacturing the base sample and the optical film. Herein, a "slow axis direction" indicates a direction exhibiting a large anisotropy of a refractive index, as mentioned above, and an angle thereof indicates an axis angle with respect to the stretching direction of the biaxial polyimide film as a reference (0°).

(Measurement of slow axis direction)

(1) A slow axis direction of the biaxial polyimide film before being irradiated with polarized UV light was detected by using a spectroscopic ellipsometer (trade name of M-220: manufactured by JASCO Corporation).

(2) Next, a slow axis direction of the biaxial polyimide film after being irradiated with polarized UV light (a surface-modified retardation film) was detected similarly.

(3) Moreover, a liquid crystal layer containing a nematic liquid crystal was formed on the surface of the biaxial polyimide film that was irradiated with polarized UV light, and a slow axis direction of the liquid crystal layer was detected. The slow axis direction detected at this stage was the slow axis direction of the liquid crystal layer, which corresponded to a direction exhibiting a large anisotropy of a refractive index on the surface of the surface-modified polyimide film. Herein, the biaxial polyimide film of Comparative Example 1 was not irradiated with polarized UV light, and the liquid crystal layer was formed directly on the surface thereof.

In the above-described step (3), the liquid crystal layer was formed as follows. A rod-like nematic liquid crystal compound (trade name of 5CB; manufactured by Merck and Co., Inc.) was applied on the surface of the surface-modified polyimide film that was irradiated with polarized UV light. The formed liquid crystal layer had a thickness (2 μm) that was larger than retardation (Δnd) of the surface-modified polyimide film, where the Δnd of the surface-modified polyimide film was 113 nm, and Δnd of the liquid crystal layer was 400 nm.

Results of the slow axis directions in the steps (1) to (3) will be shown in Table 1 below.

[Table 1]

| | (1) | (2) | (3) |
|---|---|---|---|
| Example 1 | 0 | 0 | 90 |
| Example 2 | 0 | 0 | 135 |
| Comparative Example 1 | 0 | - | 0 |

As shown in Table 1, in the optical film of Comparative Example 1 that was not irradiated with polarized UV light, the slow axis direction of the biaxial polyimide film and the slow axis direction of the liquid crystal layer were the same (the axis direction was 0°). Whereas, in the optical films of Examples 1 and 2, the surface of the biaxial polyimide film was irradiated with polarized UV light so that the surface would be modified, and thus the slow axis direction of the liquid crystal layer formed on the surface was changed with respect to the slow axis direction of the polyimide film. Specifically, in the optical film of Example 1 that was irradiated with polarized UV light in the stretching direction of the biaxial polyimide film, the slow axis direction of the liquid crystal layer was changed by 90° from the slow axis direction of the polyimide film, and in the optical film of Example 2 that was irradiated with polarized UV light in the direction at 45° with respect to the stretching direction of the polyimide film, the slow axis of the liquid crystal layer was further changed by 45°, that was, changed by 135° from the slow axis direction of the polyimide film. As mentioned above, if the surface of the biaxial polyimide film was modified by being irradiated with polarized UV light, the slow axis direction of the liquid crystal layer was changed, thereby manufacturing a biaxial optical film having different anisotropies between its inside, that is, the polyimide film, and its surface side, that is, the liquid crystal layer.

(Example 3)

A liquid crystal solution containing: 20 wt% of a nematic liquid crystal compound (trade name of Paliocolor LC242; manufactured by BASF AG); 1 wt% of a photoinitiator (trade name of IRGACURE 907: manufactured by Ciba Specialty Chemicals Inc.); and 79 wt% of toluene was prepared. Then, a surface of a TAC film base (length of 200 m, width of 350 mm, thickness of 80 μm, manufactured by Fuji Photo Film Co., Ltd.) was subjected to a rubbing treatment, and the liquid crystal solution was applied on this surface by spin coating and was dried at 90°C for 3 minutes, thereby forming a coating film. This coating film was irradiated with UV light of 800 mJ/cm$^2$ (wavelength of 365 nm) by using a high-pressure mercury lamp so as to cure the liquid crystal material, thereby forming a cured film. Herein, since the liquid crystal compound was aligned on the base, and subsequently was polymerized by the UV irradiation while being in this state, the obtained cured film had non-liquid crystallinity. This cured film was an uniaxial polymer film(positive A-plate) showing the optical characteristics of the uniaxial alignment that is represented by "nx > ny = nz". In addition, if the laminate of the base and the cured film in a crossed Nicols state was observed by using a polarizing microscope while being rotated by 360° within a plane, when an alignment axis direction of the cured film corresponded to a polarization axis of the polarizing plate (at 4 positions at angular intervals of 90°), black display was observed.

A surface of the uniaxial polymer film on the TAC film was irradiated with polarized UV light (wavelength of 310 nm) for 1 hour by using the polarized UV light exposure apparatus. Herein, the irradiation with polarized UV light was conducted in a direction at 45° with respect to a stretching direction of the uniaxial polymer film. Thereby, a surface-modified polymer film (surface-modified retardation film) was manufactured. Herein, a slow axis of this surface-modified retardation film was measured before and after the irradiation with polarized UV light, and from the result that there was no change therebetween, it was recognized that the optical characteristics of the uniaxiality of the surface-modified retardation film was not changed at all by the irradiation with polarized UV light.

Subsequently, for measuring a change in alignment of the surface-modified retardation film, a liquid crystal layer was formed on the surface of the surface-modified retardation film in the same manner as Example 1 above, thereby manufacturing an optical film. Then, this optical film in a crossed Nicols state was observed by using the polarizing microscope similarly to the above-described manner, but a black part was not observed at all. Thus, the surface-modified polymer film was in a black display state, on the other hand, a black part was not found in the liquid crystal layer formed on the surface-modified polymer film (surface-modified retardation film). Thereby, it was recognized that the surface-modified retardation film as a first layer and the liquid crystal layer as a second layer show different alignment directions, and from this fact, it could be proven that the inside of the surface-modified retardation film and the surface thereof had different anisotropies.

(Example 4)

The polymer film was modified in the same manner as Example 3 above, except forming an uniaxial polymer film showing negative optical characteristics of "nx = ny > nz" (negative C-plate) on the TAC film, instead of forming the uniaxial polymer film showing "nx > ny = nz", according to a method described below. Herein, the negative C-plate was manufactured by a method described below. Then, a change in alignment of the obtained surface-modified retardation film was evaluated in the same manner as Example 3 above. As a result, an effect similar to that of Example 3 could be obtained.

A liquid crystal solution containing: 17.7 wt% of a nematic liquid crystal compound (trade name of Paliocolor LC242; manufactured by BASF AG); 2.3 parts by weight of a chiral dopant (trade name of LC 756: manufactured by BASF AG); 1 part by weight of a photoinitiator (trade name of IRGACURE 907: manufactured by Ciba Specialty Chemicals Inc.); and 80 parts by weight of toluene was prepared. Then, on the surface of the TAC film base (length of 200 m, width

of 350 mm, thickness of 80 μm, manufactured by Fuji Photo Film Co., Ltd.), the liquid crystal solution was applied, and was dried at 70°C for 4 minutes, thereby forming a coating film. This coating film was irradiated with UV light of 200 $mJ/cm^2$ (wavelength of 365 nm) by using a high-pressure mercury lamp so as to cure the liquid crystal material, thereby forming a cured film (thickness of 4 μm).

## Industrial Applicability

As mentioned above, the retardation film of the present invention has not only a function as a retardation film but also a function as an alignment film. Thus, on the alignment surfaces of the retardation film of the present invention, birefringent layers having different alignment directions can be formed directly. The thus obtained laminated retardation film is thin, can have wide variety of optical characteristics due to the difference between the alignment directions of both of the birefringent layers, and thus the laminated retardation film is exceedingly useful, and the application thereof is not limited and wide.

## Claims

1. A retardation film, showing birefringence, wherein
the said retardation film comprises a non-liquid crystal polymer,
the non-liquid crystal polymer is aligned,
alignment of the non-liquid crystal polymer on at least one of surfaces of the retardation film is different from alignment of the non-liquid crystal polymer on an inside of the retardation film, and
the surface having the alignment that is different from the alignment on the inside functions as an alignment surface.

2. The retardation film according to claim 1, having a function as an alignment film.

3. The retardation film according to any one of claims 1 and 2, wherein optical characteristics show any of formulae (I) to (III) below,

$$nx = ny > nz \quad (I)$$

$$nx > ny > nz \quad (II)$$

$$nx > ny = nz \quad (III),$$

where, in the above formulae (I) to (III), nx, ny and nz respectively indicate refractive indices in an X-axis direction, a Y-axis direction and a Z-axis direction in the retardation film, the X-axis corresponds to an axial direction exhibiting a maximum refractive index within a plane of the retardation film, the Y-axis corresponds to an axial direction perpendicular to the X-axis within the plane, and the Z-axis corresponds to a thickness direction perpendicular to the X-axis and the Y-axis.

4. The retardation film according to any one of claims 1 to 3, wherein the non-liquid crystal polymer contains at least one polymer selected from the group consisting of polyamide, polyimide, polyester, polyetherketone, polyaryletherketone, polyamideimide and polyesterimide.

5. The retardation film according to any one of claims 1 to 3, wherein the non-liquid crystal polymer is a polymer of a liquid crystal compound.

6. A method for manufacturing a retardation film, comprising a step of forming an alignment surface by irradiating at least one of surfaces of a polymer film showing birefringence with polarized light so as to change an alignment direction of only the surface of the polymer film that is irradiated with the polarized light.

**7.** The manufacturing method according to claim 6, wherein the polarized light is linearly polarized light.

**8.** The manufacturing method according to any one of claims 6 and 7, wherein the polarized light is polarized ultraviolet light.

**9.** The manufacturing method according to claim 8, wherein the polarized light is polarized ultraviolet light of 200 nm to 400 nm.

**10.** The manufacturing method according to any one of claims 6 to 9, wherein the polymer film is a film containing a non-liquid crystal polymer.

**11.** The manufacturing method according to claim 10, wherein the non-liquid crystal polymer is at least one polymer selected from the group consisting of polyamide, polyimide, polyester, polyetherketone, polyaryletherketone, polyamideimide and polyesterimide.

**12.** The manufacturing method according to any one of claims 10 and 11, further comprising a manufacturing step for manufacturing the polymer film showing the birefringence by applying a coating solution containing the non-liquid crystal polymer on a surface of a base.

**13.** The manufacturing method according to claim 12, wherein the obtained polymer film showing the birefringence is further stretched or shrunk in the manufacturing step.

**14.** The manufacturing method according to claim 13, wherein, in the polymer film showing the birefringence before being stretched or shrunk, a birefringent index ($\Delta n$) shown by a formula below is 0.01 or more,

$$\Delta n = nx - nz,$$

where, in the above formula, nx and nz respectively indicate refractive indices in an X-axis direction and a Z-axis direction in the birefringent layer, and the X-axis direction corresponds to an axial direction exhibiting a maximum refractive index within a plane of the birefringent layer, and the Z-axis corresponds to a thickness direction perpendicular to the X-axis.

**15.** The manufacturing method according to claim 10, wherein the non-liquid crystal polymer is a polymer containing a polymer of a liquid crystal compound.

**16.** The manufacturing method according to claim 15, further comprising a manufacturing step for manufacturing the polymer film showing the birefringence,
the manufacturing step comprising:

applying a coating solution containing the liquid crystal compound on a surface of an alignment film so as to form a coating film;
subjecting the coating film to a heat treatment so as to align the liquid crystal compound according to an alignment direction of the alignment film; and then
polymerizing the liquid crystal compound.

**17.** A retardation film manufactured by the manufacturing method according to any one of claims 6 to 16.

**18.** The retardation film according to claim 17, having a function as an alignment film.

**19.** A method for manufacturing a laminated retardation film in which two or more birefringent layers with different alignment directions are laminated,
the method comprising:

preparing the retardation film according to any one of claims 1 to 5, 17 and 18;
applying a coating solution containing a liquid crystal compound on the alignment surface of the retardation film so as to form a coating film; and

subjecting the coating film to a heat treatment for aligning the liquid crystal compound according to an alignment direction of the alignment surface so as to form a birefringent layer.

**20.** A laminated retardation film manufactured by the manufacturing method according to claim 19.

**21.** An optical film comprising the retardation film according to any one of claims 1 to 5, 17 and 18, or the laminated retardation film according to claim 20.

**22.** The optical film according to claim 21, further comprising a polarizing element.

**23.** An image display apparatus, comprising the optical film according to any one of claims 21 and 22.

**24.** The image display apparatus according to claim 23, which is a liquid crystal display.

**25.** The image display apparatus according to claim 24, which is at least one self-light-emitting image display selected from the group consisting of an electroluminescence (EL) display, an organic electroluminescence (EL) display, a plasma display (PD) and a FED (Field Emission Display).

**INTERNATIONAL SEARCH REPORT**

International application No.
PCT/JP2004/018936

A. CLASSIFICATION OF SUBJECT MATTER
Int.Cl$^7$ G02B5/30, G02F1/13363

According to International Patent Classification (IPC) or to both national classification and IPC

B. FIELDS SEARCHED

Minimum documentation searched (classification system followed by classification symbols)
Int.Cl$^7$ G02B5/30, G02F1/13363

Documentation searched other than minimum documentation to the extent that such documents are included in the fields searched

| | | | |
|---|---|---|---|
| Jitsuyo Shinan Koho | 1926-1996 | Toroku Jitsuyo Shinan Koho | 1994-2005 |
| Kokai Jitsuyo Shinan Koho | 1971-2005 | Jitsuyo Shinan Toroku Koho | 1996-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br><br>Y<br>A | JP 9-222605 A (Rolic AG),<br>26 August, 1997 (26.08.97),<br>Full text; all drawings; particularly, Claims 1, 3, 9, 18, 20, 21, 24 to 25<br>& EP 756193 A1 & US 6215539 B1<br>& SG 83086 A1 & US 6300991 B1<br>& US 6608661 B1 & KR 97007445 A<br>& CN 1146561 A & KR 257095 B1 | 1-2,6-10, 17-25<br><br>3,4,11-14<br>5,15-16 |
| Y | WO 03/091767 A1 (Nitto Denko Corp.),<br>06 November, 2003 (06.11.03),<br>Full text; all drawings<br>& JP 2004-226945 A | 1-14,17-25 |

[X] Further documents are listed in the continuation of Box C. [ ] See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 22 March, 2005 (22.03.05) | 05 April, 2005 (05.04.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

International application No.
PCT/JP2004/018936

C (Continuation). DOCUMENTS CONSIDERED TO BE RELEVANT

| Category* | Citation of document, with indication, where appropriate, of the relevant passages | Relevant to claim No. |
|---|---|---|
| X<br>A | JP 11-72621 A (Sharp Corp.), 16 March, 1999 (16.03.99), Full text; all drawings; particularly, Claims 1, 5, 8<br>& US 6157427 A & KR 99013588 A<br>& KR 312149 B | 1,2,5,19-25<br>3-4,6-18 |
| Y | KIRYONG HA. et al., Spectroscopic Studies on the Liquid Crystal Alignment Mechanism for Polarized UV-Exposed Organosoluble 6FDA-TFMB Polyimide Films, Molecular Crystals and Liquid Crystals, 2001, Vol.357, pages 263 to 280 | 4,11-14 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 5344916 A
- US 6074709 A
- JP 2631015 B
- JP 2000511296 A
- JP 8511812 A
- JP 2001049110 A
- JP 10508048 A
- JP 2002014529 A
- JP 2001343529 A
- WO 0137007 A


### Non-patent literature cited in the description


- *Liquid Crystals,* 1999, vol. 26, 575-580